Europäisches Patentamt

European Patent Office

Office européen des brevets

(11) Publication number: **0 081 922**
**B1**

(12) **EUROPEAN PATENT SPECIFICATION**

(45) Date of publication of patent specification: **11.09.85**

(51) Int. Cl.⁴: **H 03 F 19/00**, H 03 K 19/195

(21) Application number: **82306174.2**

(22) Date of filing: **19.11.82**

(54) Josephson junction device.

(30) Priority: **19.11.81 US 323144**

(43) Date of publication of application:
**22.06.83 Bulletin 83/25**

(45) Publication of the grant of the patent:
**11.09.85 Bulletin 85/37**

(84) Designated Contracting States:
**CH DE FR GB IT LI**

(56) References cited:
**US-A-3 983 419**
**US-A-4 117 354**
**US-A-4 275 314**

**APPL. PHYS. LETT., vol. 35, no. 9, 1. November 1979,**

**C.A. Hamilton et al. "A superconducting sampler for Josephson logic circuits", pages 718-719**

**APPL. PHYS. LETT., vol. 35, no. 9, 1. November 1979**

**IBM TECHNICAL DISCLOSURE BULLETIN, vol. 21, no. 11, April 1979**

(73) Proprietor: **SPERRY CORPORATION**
**1290, Avenue of the Americas**
**New York, N.Y. 10019 (US)**

(72) Inventor: **Josephs, Richard Michael, Dr.**
**220 Limestone Lane**
**Willow Grove, Pa. 19090 (US)**
Inventor: **Wang, Tsing-Chow, Dr.**
**3011 Black Swift Road**
**Norristown, Pa. 19403 (US)**

(74) Representative: **Orchard, Oliver John**
**JOHN ORCHARD & CO. Staple Inn Buildings**
**North High Holborn**
**London WC1V 7PZ (GB)**

(56) References cited:
**T.R. GHEEWALA "An off-chip long lines receiver", pages 4713-4714**

**IEEE TRANSACTIONS ON MAGNETICS, vol. MAG.-15, no. 6, November 1979**

**T.A. FULTON et al. "Josephson junction current-switched logic circuits"**

**IEEE TRANSACTIONS ON MICROWAVE THEORY AND TECHNIQUES, vol. MTT-28, no. 5. May 1980 T.V. DUZER "Josephson digital devices and circuits", pages 490-500**

Courier Press, Leamington Spa, England.

## Description

The present invention relates to a Josephson junction device having voltage amplification.

It is well known that a Josephson junction device displays no impedance when the current passing through the junction is at a value less than the critical current $I_0$. When a value of critical current $I_0$ is reached, the Josephson junction becomes resistive and switches from the zero voltage state to the voltage gap state. The gap voltage for a Josephson junction remains constant and does not vary. When a constant current source is connected to a Josephson junction device, a major portion of that current can be steered or diverted to a parallel load or loads when the Josephson junction switches. The nature of a Josephson junction is that it either displays a voltage or no voltage; thus, by definition, it does not amplify an input voltage.

Josephson junction load drivers usually employ a plurality of parallel branches and a plurality of Josephson junction devices. All of these load drivers are limited to modest gain and modest fan-out. Circuits of this type are shown and described in IEEE Transactions on Magnetics, volume 15, No. 6, November, 1979 at pages 1876—1879 and also in IEEE International Electron Devices meeting, Washington D.C., December 3—5, 1979 at pages 482—484.

In Appl. Phys. Lett., Vol. 35, No. 9, 1 November, 1979 at pages 718 and 719, there is disclosed a method for automating a technique which is used to sample rise time in superconducting logic circuits in which the time at which a biassed Josephson Junction switches under the influence of an applied signal is measured. The sampled voltage is compared with a reference level and the difference signal is integrated to drive a sampling timebase input. The integrator forms a part of a servo loop and the sampling time is varied with variations in the integrator output, whereby the time base input provides a measure of the time at Josephson junction switches.

There is no suggestion that the circuit disclosed in the article could be used to amplify an input voltage and the present invention is distinguished from anything disclosed therein by the arrangement claimed in claim 1.

The voltage and currents which occur in Josephson junction technology are very small, typical voltages gaps being of the order of one or two millivolts, and the threshold currents being measured in micro amperes. Such magnitudes are of course quite incompatible with transistor logic circuits and problems of noise arise in attempting to amplify them.

It is an object of the present invention to provide a Josephson junction device with a high voltage gain, and in which, moreover, the amplification occurs at low temperatures within the cryogenic container so as to be substantially noise-free.

The invention will be further described with reference to the accompanying drawings, in which

Figure 1 is a Josephson junction circuit employing two Josephson Atto-Webber Switches (JAWS) arranged in series and having an external output sensing logic circuit;

Figure 2 is a schematic circuit showing the generic elements of the Josephson junction amplifier of the present invention;

Figure 3 is a schematic circuit showing a modified embodiment of the Josephson junction amplifier of Figure 2;

Figure 4 is a typical current vs. voltage characteristic curve for a Josephson junction;

Figure 5 is a schematic waveform of current vs. time showing a typical input signal to the Josephson junction voltage amplifier;

Figure 6 is a schematic drawing showing voltage out vs. variable voltage in for the novel Josephson junction voltage amplifier;

Figure 7 is a schematic drawing showing a typical current vs. voltage characteristic for a Josephson junction without any amplification; and

Figure 8 is a schematic drawing showing current vs. the voltage output from a novel Josephson junction voltage amplifier.

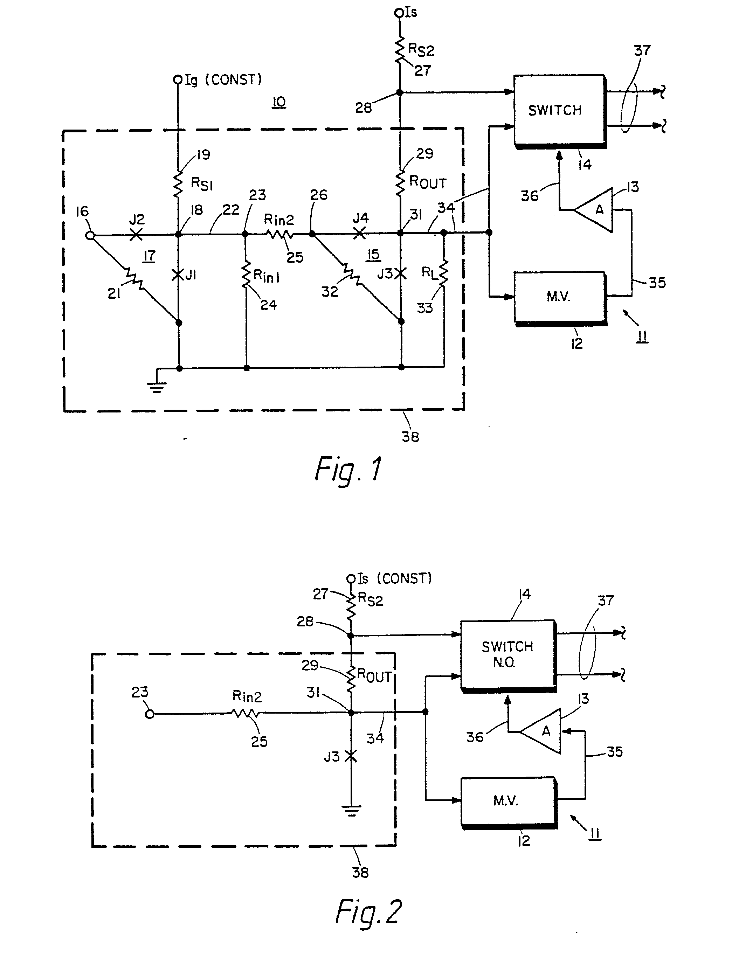

Figure 1 shows a voltage amplifier 10 according to the present invention in the form in which it was originally tested. In the prior art two Josephson Atto-Webber Switches (JAWS) have been coupled in series in the manner shown. According to one aspect of the invention, the sensing means 11 at the output comprises a one shot multivibrator 12, an amplifier 13 and a normally-open voltage sampling switch 14. These together with the JAWS device 15, constitute a high gain voltage amplifier. The operation of a typical JAWS switch occurs when a constant gate current $I_g$ is being applied through a source resistor 19($R_{s1}$), and through a Josephson junction $J_1$ which is initially in its zero voltage state. When an additional input current is applied at node 16, it passes through Josephson junction $J_2$ to node 18 and through the Josephson junction $J_1$ to ground. The input current increases until a point is reached when a critical current $I_0$ is present in Josephson junction $J_1$ which causes it to switch from its low impedance state to its high impedance state. Switching of $J_1$ causes a portion of the gate current $I_g$ to flow through $J_2$ and through branch resistor 21 to ground, thus causing $J_2$ to switch, $J_1$ and $J_2$ being both in a high impedance state cause a major portion of the input current at node 16 to be diverted through resistor 21 to ground. Most of the gate current $I_g$ appearing at node 18 now appears on input line 22 to node 23. In the Figure 1 embodiment, the resistors 24 and 25, which are labelled as $R_{in1}$ and $R_{in2}$, were chosen to be equal, so that the current at node 23 was equally split into two branches. The current $I_{in}$ which flows through resistor 25 ($R_{in2}$) develops the voltage input $V_{in}$ for the circuit tested as shown in Figure 1. The voltage input node 26 is initially at ground, since the Josephson junctions

$J_3$ and $J_4$ are in the low impedance state. The input source current $I_s$ is being applied through the source resistor 27 ($R_{s2}$) to the first ouput node 28 and flows through the output resistor 29 to the node 31. Node 31 is initially grounded, since the Josephson junction $J_3$ and the Josephson junction $J_4$ are in their low impedance states. When the input current $I_{in}$ being applied at node 26 becomes sufficient to switch the Josephson junction $J_3$ to the high impedance state, the major portion of the current flowing through source resistor 27 and output resistor 29 to node 31 now flows through Josephson junction $J_4$ and resistor 32 to ground. Subsequently, the Josephson junction $J_4$ switches causing the source current $I_s$ to flow through load resistor 33. An increase in voltage occurs on voltage output line 34 which is applied to the one shot multivibrator 12 and the voltage sampling switch 14. The multivibrator 12 generates an output signal on line 35 which is amplified at amplifier 13 and applied via line 36 to sampling switch 14 which has normally open contacts. The signal indicative of the switching of the junctions $J_3$ and $J_4$ causes the switch 14 to close and the voltage across output resistor 29 is coupled to the voltage amplifier output lines 37.

It will be understood that at the time junction $J_3$ and $J_4$ switch, the current $I_s$ plus the input current $I_{in}$ at node 26 is equal to $V_{in}/R_{in2}$. In similar manner the source current $I_s$ is equal to the $V_{out}$ appearing across output resistor 29 divided by the value of the output resistor 29. Thus $V_{out}/R_{out} + V_{in}/R_{in2} = I_0$. Rearranging the equation and solving for $V_{out}$, it will be found that $V_{out} = -(R_{out}/R_{in2}) V_{in} + R_{out} I_0$. In this equation the latter value $R_{out} I_0$ is a constant; thus, the amount of voltage gain which may be obtained in the novel voltage amplifier can be as much as 400 to 1 by the proper selection of the values of the resistors $R_{out}$ (29) and $R_{in2}$ (25).

The dash lines 38 indicate the cryogenic container in which the Josephson junction devices are placed, therefore, it will be understood that all of the elements inside the dash line 38 are maintained at cryogenic temperature. Sensing means 11 may, but need not, be inside the cryogenic container 38, and preferably are maintained outside.

Figure 2 shows the principal elements of a Josephson junction voltage amplifier according to the invention. The voltage input is applied to node 23 and develops a current across input resistor 25. Initially, node 31 is at ground potential, because the Josephson junction $J_3$ is in the low impedance state. The source current $I_s$ is applied through the source resistor 27 and appears at the first output node 28. The current flows through the output resistor 29 and appears at the second output node 31 before flowing through Josephson junction $J_3$ to ground. When the Josephson junction $J_3$ switches, it goes to its high impedance state, causing a voltage increase to appear at node 31. The voltage increase is sensed on line 34 and applied to multivibrator 12. The output of multivibrator 12 is amplified in amplifier 13 and applied via line 36 to the voltage sampling switch 14. The signal on line 36 causes the normally open contacts in switch 14 to close, and the amplified voltage output signal is coupled to output lines 37. The gain produced by the circuit shown in Figure 2 is substantially the same as that shown in Figure 1, wherein the voltage gain is equal to $R_{out}(29)/R_{in2}(25)$.

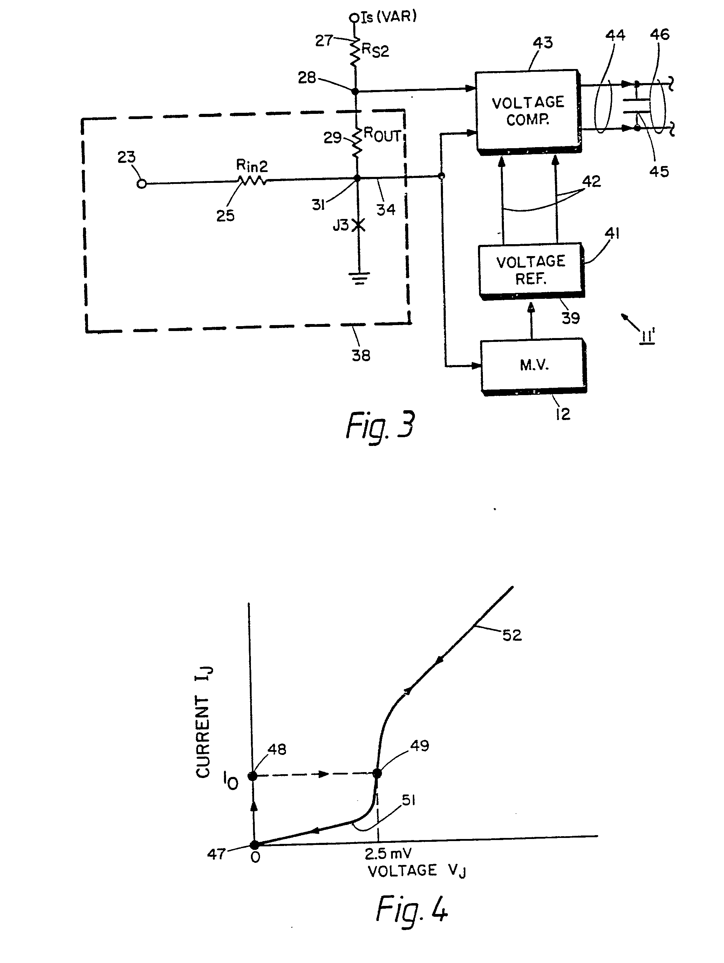

Figure 3 shows a modified embodiment of Figure 2 for use in a sample-and-hold application. The Josephson junction device $J_3$ inside the cryogenic container 38 is identical to that shown in Figure 2. The current source $I_s$ in Figure 3 may be variable, and supplies current through the source resistor 27 and the output resistor 29 to generate voltages at the output node 28 and at node 31, which are applied to a voltage comparator 43. The voltage at node 31 on line 34 is also applied to the multivibrator 12 which senses the voltage change when $J_3$ switches. This generates a signal on line 39, causing the voltage reference 41 to generate output signals on lines 42, which are compared with the output voltage across resistor 29 by the voltage comparator 43. When the output voltage across resistor 29 is changing and crosses through the value of the voltage reference on output lines 42, the output voltage is generated on output lines 44. It will be understood that the voltage on lines 44 is sensed at a particular instant in time, and is not a dc voltage. If a direct voltage is desired from the output voltage comparator 43 a capacitor 45 may be placed across the lines and a dc voltage sensed at output lines 46. The formula for $V_{out}$ is:—

$$V_{out} = -(R_{out}/R_{in2})V_{in} + R_{out}I_0$$

The reference voltage on lines 42 is $R_{out} I_0$ and this reference voltage may be eliminated from the formula, leaving $-V_{out}$ as a ratio of $R_{out}/R_{in2}$. Voltage reference 41 cancels out the constant voltage term, $R_{out}I_0$.

Figure 4 is a current vs. voltage characteristic curve for a typical Josephson junction. When the current is increased from the zero point 47 toward the critical current point 48, there is no voltage across the Josephson junction. When the junction reaches its critical current state $I_0$, the voltage increases abruptly from zero to a gap voltage, shown at point 49. If the current is subsequently decreased, the voltage across the Josephson junction follows the sub gap resistance path shown as curve 51; however, if the current in the Josephson junction is subsequently increased from point 49 it follows a normal resistance path shown as curve 52. The arrows on the curves 51 and 52 indicate the direction in which the current in the junction is changing.

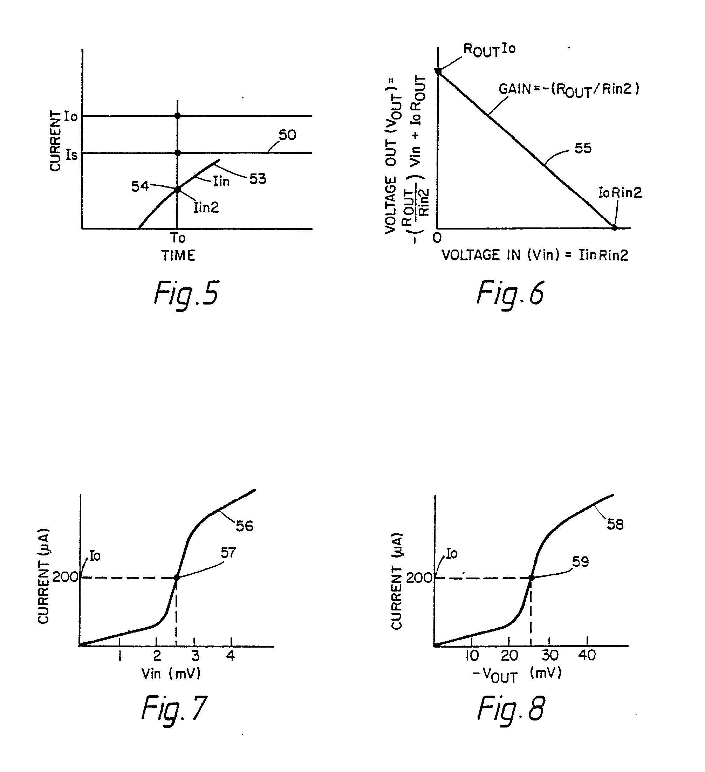

Figure 5 shows an input current waveform which may be used to explain the current vs. voltage characteristic curve of Figure 4. Assuming that the source current $I_s$ in Figure 2 is constant and shown at line 50, the input current $I_{in}$, shown at curve 53, is also applied to node 31, and adds to the source current, so that $I_{in} + I_s$ eventually

equals $I_0$, which occurs at point 54. It is possible for $I_{in}$ to increase past the critical current point $I_0$ which would explain the normal resistance part 52 of the waveform shown in Figure 4. It will be understood that in the Josephson junction amplifier circuit of this invention, the maximum voltage amplification is sensed at critical time $T_0$ when the current $I_{in2}$ plus $I_s$ is just equal to $I_0$.

Refer now to Figure 6, which will assist in explaining the voltage gain achieved by the Josephson junction amplifiers of Figures 1 through 3. The variable input to Figure 6 is shown as voltage $V_{in}$ on the abscissa. The amplified output voltage $V_{out}$ is shown on the ordinate. The ratio of voltage out to voltage in is defined as the voltage amplification gain of the Josephson junction device and it is to be understood that the gain ratio is defined by the slope of the curve 55 and is equal to $-R_{out}/R_{in2}$. The Josephson junction voltage amplifier may be used as an amplifier or an amplifier inverter.

Figure 7 is a schematic drawing for a current vs. voltage characteristic of a typical Josephson junction device under test. Waveform 56 shows that for a single Josephson junction device that an input current of 200 micro amperes will typically produce an output voltage of approximately 2.5 millivolts. The point 57 on curve 56 is at the critical current $I_0$ level.

Figure 8 is a schematic characteristic curve of current vs. voltage of a similar Josephson junction device as shown in Figure 7 after it has been embodied into the novel Josephson junction amplifier circuits of figures 1 to 3. Curve 58 is substantially identical in shape to curve 56 except that the voltage output has been amplified by a factor of 10. Thus at point 59 an input current of 200 micro amps is shown producing a negative output voltage of 25 millivolts when the constant voltage term $R_{out}I_0$ is cancelled out. It will be understood that the ratio of the output resistor $R_{out}$ to the input resistor $R_{in2}$ defines the gain of the Josephson junction voltage amplifier and may be raised to provide gains of approximately 400 to 1. Accordingly, it is now possible to amplify the low voltage portion of curve 56 where voltages of only a few millivolts are present and to detect and resolve accurately this region.

Having explained a preferred embodiment and a modification of the present invention, it will now be understood that the voltage amplifier may be embodied into numerous circuits without modification. For example, prior art logic gates employing Josephson junction devices have required room temperature amplification devices to achieve voltage levels which are compatible with the prior art utilisation and sensing devices. Employing the present Josephson junction voltage amplifier, no external level shifting or amplification circuit is required.

As a second example, it is now possible to employ a single Josephson junction device embodied into a voltage regulator. A typical prior art Josephson junction voltage regulator consists of a string of Josephson junction devices in series with the voltage across the entire string being used as the regulated voltage. It is now possible using the present invention Josephson junction voltage amplifier to employ a single Josephson junction and multiply the input voltage to any reasonable multiple at least 400 times.

As a further example, the present invention Josephson junction voltage amplifier may be employed as a microwave power output device. Power translation is possible at the frequency of resonant portion of the device characteristic curve which suggests that precision oscillators with high power are now possible employing the present invention.

The present invention Josephson junction voltage amplifier may be employed with prior art magnetometer circuits to increase their sensitivity through voltage amplification. It would appear to be possible to multiply microvolt inputs up to millivolt signals with extreme accuracy. Since the amplification is occurring at cryogenic temperatures, the final stage amplification would be more accurate by approximately two orders of magnitude than amplifiers operating at room temperature because the thermal noise is proportional to the absolute temperature.

Employing the present invention Josephson junction voltage amplifier, it is now possible to perform basic computer logic operations in a cryogenic environment and to use the output from the cryogenic amplifier to drive room temperature peripheral devices directly without level converters and amplifiers.

**Claims**

1. A Josephson junction device comprising a Josephson junction ($J_3$) in a cryogenic container and connected between a current summing node (31) and ground, and having a current input terminal (23) and a current source ($I_s$), an input resistor (25) connected between the input terminal (23) and the node (31), and output resistor (29) connected between the current source and the node, and voltage sensing means (11), which includes means (14) to sense the voltage across the output resistor (29), connected to node (31), characterised in that the means (14) to sense the voltage is connected across the output resistor (29) and includes means (12, 13) connected to the node for sensing the switching of the Josephson junction ($J_3$) from its zero resistance state to its voltage gap state and for thereupon causing the voltage sensing means (14) to sense the voltage across the output resistor (29).

2. A Josephson junction device according to claim 1 further characterised in that the means for sensing the switching of state of the Josephson junction ($J_3$) comprises a single-shot multivibrator (12) followed by an amplifier (13).

3. A Josephson junction device according to claim 1 or claim 2, further characterised in that the voltage sensing means comprises a normally open switch (14) which is closed at the instant when the Josephson junction switches its state.

4. A Josephson junction device according to claim 1 or claim 2 in which the voltage sensing means comprises a voltage comparator (43) supplied with a source of reference voltage (41).

## Patentansprüche

1. Josephson-Gerät mit einem Josephson-Übergang ($J_3$), das in einem Kältegefäß angeordnet und zwischen einem den Strom summierenden Knoten (31) und Erde angeschlossen ist, mit einer Stromeingangsklemme (23) und mit einer Stromquelle ($I_s$), wobei zwischen der Eingangsklemme (23) und dem Knoten (31) ein Eingangswiderstand (25) und zwischen der Stromquelle und dem Knoten ein Angangswiderstand (29) liegt, sowie mit einem Spannungsfühler (11), der Hilfsmittel (14) zur Abtastung der Spannung am Ausgangswiderstand (29) enthält und am Knoten (31) angeschlossen ist, dadurch gekennzeichnet, daß das Hilfsmittel (14) zur Abtastung der Spannung am Ausgangswiderstand (29) angeschlossen ist und mit dem Knoten verbundene Mittel (12, 13) zur Abtastung des Umschaltens des Josephson-Überganges ($J_3$) von Zustand des Nullwiderstandes zu seinem Zustand der Spannungslücke enthält, um die die Spannung abtastenden Hilfsmittel (14) zur Spannungsabtastung am Ausgangswiderstand (29) zu veranlassen.

2. Josephson-Gerät gemäß Anspruch 1, ferner dadurch gekennzeichnet, daß die Hilfsmittel zur Abtastung des Umschaltens des Zustandes des Josephson-Überganges ($J_3$) einen Monovibrator (12) enthalten, dem ein Verstärker (13) nachgeschaltet ist.

3. Josephson-Gerät gemäß Anspruch 1 oder Anspruch 2, ferner dadurch gekennzeichnet, daß die die Spannung abtastenden Hilfsmittel einen normalerweise offnen Schalter (14) enthalten, der in dem Augenblick geschlossen wird, in dem der Josephson-Übergang seinen Zustand umschaltet.

4. Josephson-Gerät gemäß Anspruch 1 oder Anspruch 2, bei dem die Spannung abtastenden Hilfsmittel einen Spannungskomparator (43) enthalten, der von einer Bezugsspannungsquelle (41) gespeist wird.

## Revendications

1. Dispositif à jonction de Josephson comprenant une jonction de Josephson ($J_3$) dans un récipient cryogénique et connecté entre un noeud de sommation de courant (31) et la masse, et comprenant une borne d'entrée de courant (23) et une source de courant ($I_s$), une résistance d'entrée (25) connectée entre la borne d'entrée (23) et le noeud (31), une résistance de sortie (29) connectée entre la source de courant et le noeud, et des moyens de détection de tension (11), qui comprenant des moyens (14) destinés à détecter la tension sur la résistance de sortie (29), reliés au noeud (31), caractérisé en ce que les moyens (14) destinés à détecter la tension sont montés sur la résistance de sortie (29) et comprenant des moyens (12, 13) reliés au noeud pour détecter le changement d'état de la jonction de Josephson ($J_3$) passant de son état de résistance nulle à son état d'intervalle de tension et, en conséquence de quoi, pour amener les moyens de détection de tension (14) à détecter la tension sur la resistance de sortie (29).

2. Dispositif à jonction de Josephson selon la revendication 1, caractérisé en outre en ce que les moyens destinés à détecter le changement d'état de la jonction de Josephson ($J_3$) comprennent un multivibrateur monostable (12) suivi d'un amplificateur (13).

3. Dispositif à jonction de Josephson selon la revendication 1 ou la revendication 2, caractérisé en outre en ce que les moyens de détection de tension comprennent un commutateur normalement ouvert (14) qui est fermé à l'instant où la jonction de Josephson change d'état.

4. Dispositif à jonction de Josephson selon la revendication 1 ou la revendication 2, dans lequel les moyens de détection de tension comprennent un comparateur de tension (43) fournie à partir d'une source de tension de référence (41).

Fig. 1

Fig.2

1

*Fig. 3*

*Fig. 4*

Fig.5

Fig.6

Fig.7

Fig.8